(19) Europäisches Patentamt

European Patent Office

Office européen des brevets

(11) EP 1 616 981 A1

(12) EUROPEAN PATENT APPLICATION
published in accordance with Art. 158(3) EPC

(43) Date of publication:
18.01.2006 Bulletin 2006/03

(51) Int Cl.:
*C30B 29/16* (1980.01)    *C30B 7/10* (1980.01)

(21) Application number: 04725528.6

(22) Date of filing: 02.04.2004

(86) International application number:
PCT/JP2004/004850

(87) International publication number:
WO 2004/090202 (21.10.2004 Gazette 2004/43)

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 03.04.2003 JP 2003100861

(71) Applicants:
• Tokyo Denpa Co., Ltd.
Ota-ku
Tokyo 143-0024 (JP)
• MITSUBISHI CHEMICAL CORPORATION
Tokyo 108-0014 (JP)

(72) Inventors:
• YOSHIOKA, Kenji
c/o Tokyo Denpa Co., Ltd.
Ota-ku
Tokyo 143-0024 (JP)

• YONEYAMA, Hiroshi
c/o Tokyo Denpa Co., Ltd.
Ota-ku Tokyo 143-0024 (JP)
• MAEDA, Katsumi
c/o Tokyo Denpa Co., Ltd.
Ota-ku Tokyo 143-0024 (JP)
• NIIKURA, Ikuo
c/o Tokyo Denpa Co., Ltd.
Ota-ku Tokyo 143-0024 (JP)
• SATO, Mitsuru
c/o Tokyo Denpa Co., Ltd.
Ota-ku Tokyo 143-0024 (JP)
• ITO, Masumi;
c/o Mitsubishi Chemical Group Science
Aoba-ku, Yokohama-shi
Kanagawa (JP)

(74) Representative: Vossius & Partner
Siebertstrasse 4
81675 München (DE)

(54) ZINC OXIDE SINGLE CRYSTAL

(57)    An objective of the present invention is to provide a zinc oxide (ZnO) single crystal whose electroconductivity is excellent and which has a high quality.

The invention relates to a zinc oxide single crystal whose concentration of metals other than zinc in the crystal fulfills the following equation:

$$[-cM]/[+cM] \geq 3$$

wherein M is a metal other than zinc, [-cM] is a concentration of M in a -c region in the zinc oxide crystal, and [+cM] is a concentration of M in a +c region in the zinc oxide crystal.

Fig. 3

EP 1 616 981 A1

**Description**

FIELD OF THE INVENTION

The present invention relates to a zinc oxide (hereinafter "ZnO" which is a chemical formula of the zinc oxide is used as a synonymous term) single crystal. More particularly, the invention relates to a zinc oxide (ZnO) single crystal which is employed in various fields including blue-purple, ultraviolet light-emitting device (as well as a substrate thereof), surface acoustic wave (SAW), gas sensor, piezoelectric device, transparent electroconductive body, varistor and the like, and which exerts excellent functions.

BACKGROUND OF THE INVENTION

A single crystal of a zinc oxide (ZnO) is a semiconductor having a crystalline structure of a hexagonal wurtzite compound and a large forbidden band width upon direct transition (Eg: 3.37eV). Since it has an extremely high exciton binding energy (ZnO: 60meV) when compared with other semiconductors (GaN: 21meV, ZnSe: 20meV), it is expected to serve as a highly efficient light-emitting device material. While ZnO should be prepared as a p type for realizing a light-emitting device utilizing the ZnO, the ZnO tends to become an n type and is difficult naturally to become a p type because of a tendency of undergoing an oxygen deficiency or interstitial zinc defect.

Currently, a large number of research institutes are studying the conversion of a ZnO into a p type, which is expected, if realized, to result in a revolution in the fields of photoelectronics and energy. Also since its crystalline structure and lattice constant are similar to those of a GaN which has actually been utilized for several years as a blue light-emitting diode (LED) (lattice mismatch: about 2%) and also since it is possible to be produced in future at a low cost, it is focused on also as a GaN film forming substrate for which sapphire or SiC are mainly employed in these days.

The growth of a ZnO single crystal is reported as described below.

A non-patent reference 1 describes a growth of a ZnO single crystal by a hydrothermal method, and this growth method employs a ZnO sintered form placed on the bottom of a crystal growth chamber and a ZnO crystal seed placed beneath the top of this growth chamber, to which then a solvent as an alkaline aqueous solution (hereinafter referred to as alkaline solvent) composed of KOH and LiOH is filled. In this condition, the growth chamber is operated at an internal temperature of 370 to 400°C under a pressure of 700 to 1000 kg/cm$^2$, while maintaining the temperature on the bottom of the growth chamber higher by 10 to 15°C than the temperature beneath the top, whereby allowing a single crystal of ZnO to grow.

A ZnO single crystal thus formed has an excess of the Zn atom which is ten and several ppm to twenty and several ppm and also has an electroconductivity of 10° to 10$^{-2}$ l/Ω·cm due to a reductive atmosphere of the growth when using only an alkaline solvent as a growth solution. Accordingly, this zinc oxide single crystal is not suitable for an acoustoelectric effect device because of its too high electroconductivity. As a result, hydrogen peroxide ($H_2O_2$) is added to impart the growth system with an oxygen atmosphere in an attempt to obtain a highly purified ZnO single crystal.

However, even in the case of a ZnO single crystal grown in the presence of $H_2O_2$ as described above, the electroconductivity was as low as 10$^{-8}$ to 10$^{-10}$ l/Ω·cm, which is not suitable for an acoustoelectric effect device. As a result, the surface of a ZnO single crystal thus obtained is subj ected to a vapor deposition with Zn to establish a Zn excess state whereby improving the electroconductivity.

Nevertheless, the improvement of the electroconductivity by the Zn vapor deposition described above is accomplished only in the region close to the surface of the ZnO single crystal after the vapor deposition treatment, and still involves a problematic unevenness of the electroconductivity over the entire single crystal. In addition, such a vapor deposition requires a large-scaled apparatus, which is disadvantageous from the economic point of view.

Also in a patent reference 1, a piezoelectric semiconductor consisting of a ZnO single crystal of about 1 inch at maximum obtained by doping the ZnO with a trivalent metal such as Al is produced. This semiconductor is obtained by a doping with a trivalent metal at 5 to 120 ppm and purported to have an electroconductivity of 10$^{-3}$ to 10$^{-6}$ l/Ω·cm. The method for producing a single crystal according to the patent reference 1 is a method comprising providing a ZnO sintered form raw material in a raw material charge part on the bottom of a growth chamber and a ZnO crystal seed in a crystal growth part beneath the top of the growth chamber, placing an alkaline solvent in the chamber, and allowing to the ZnO single crystal to be grown under a hydrothermal condition while adjusting the temperature inside of the chamber so that the temperature of the raw material charge part becomes higher than the temperature of the crystal growth part, wherein $H_2O_2$ is mixed in said alkaline solution to form the ZnO single crystal and this single crystal is doped with a trivalent metal whereby controlling the electroconductivity. In such a method, the doping with a trivalent metal serves to improve the electroconductivity not only of a region close to the crystal surface but also through the entire single crystal of ZnO, whereby improving the uniformity of the electroconductivity.

However, the mobility (the rate of carrier movement) of the ZnO single crystal described in the patent reference 1 which is specified to be 30 cm$^2$/V·sec or higher, preferably 60 cm$^2$/V·sec or higher, which is still insufficient for a semiconductor property and should further be improved.

[Non-patent reference 1]
"Growth kinetics and morphology of hydrothermal ZnO single crystal", N.Sakagami, M.Wada, YOGYOKYOKAISHI, 82[8], 1974.
[Patent reference 1]
JP-A-6-90036

## DISCLOSURE OF THE INVENTION

The problems involved in the prior art described above include a difficulty in producing a highly pure large-sized ZnO single crystal capable of being employed as various materials efficiently. In addition, a zinc oxide single crystal of a prior art contains a large amount of impurities, and its electroconductivity is not satisfactory for a semiconductor property with the uniformity thereof being also not sufficient.

The present inventors made an effort to overcome the problems of the prior art described above and finally discovered that a certain condition upon a hydrothermal process allows the growth of a ZnO single crystal whose size is as surprisingly large as 2 inch which can not be achieved by any prior art, thus establishing the invention. Also with regard to the characteristics of the resultant ZnO single crystal, it is discovered that the concentration distribution of trace metals in the crystal is specific, and that this specific concentration gradient of the metals allows the crystal to possess two distinct regions, namely a highly electroconductive region and an optically excellent region, which make this crystal extremely useful industrially.

Thus, the invention is a zinc oxide single crystal whose concentration of metals other than zinc in the crystal fulfills the following equation:

$$[-cM]/[+cM] \geq 3$$

wherein M is a metal other than zinc, [-cM] is a concentration of M in a -c region in the zinc oxide crystal, and [+cM] is a concentration of M in a +c region in the zinc oxide crystal.

A ZnO single crystal of the invention has an excellently transparent +c side which promotes its use in a field of optical characteristics, while its excellently electroconductive -C side makes it useful in a device such as a light-emitting device (LED) substrate and the like. It can be applied not only to a bulk device but also a wide range of substrates.

## BRIEF DESCRIPTION OF THE INVENTION

Fig. 1 is a schematic view of a structure of a single crystal growth apparatus for growing an inventive ZnO single crystal.
Fig. 2 is a ZnO single crystal growth region.
Fig. 3 is a sectional view when being cut in the direction of a c axis of a ZnO single crystal.
Fig. 4 shows an infrared spectrum characteristics of an inventive ZnO single crystal.

In the figures, sign 3 is a crystal seed, sign 11 is a single crystal growth apparatus, sign 12 is an autoclave, sign 13 is a chamber body, sign 14 is a lid, sign 15 is a fixation part, sign 16 is a heater, sign 17 is a packing, sign 20 is a growth chamber, sign 21 is a frame, sign 22 is a platinum lead, sign 24 is an internal baffle plate, sign 25 is an external baffle plate, sign 26 is a raw material, sign 30 is a bellows.

## BEST MODE FOR CARRYING OUT THE INVENTION

The invention is explained below in detail.

The invention relates to a novel ZnO single crystal, a method for producing the same is not limited particularly. Nevertheless, such a production becomes possible practically for the first time by employing a specific raw material under a precisely specified hydrothermal synthesis condition. Preferred (representative) embodiments of such a production method are detailed below.

For the purpose of producing an inventive high quality and high pure ZnO single crystal containing a reduced amount of impurities in a highly reproducible manner, it is required to select only a highly pure raw material containing a reduced amount of impurities, to suppress the contamination with the impurities during the production processes as far as possible, to determine the temperature and pressure conditions empirically which allow the crystals to grow at an appropriate rate, and to ensure the design of the reaction growth chamber fulfilling such requirements advantageously.

First, as a raw material for growing a high quality ZnO single crystal, a further highly pure ZnO powder is required, and one whose purity is 99.999% or higher is required usually. Such a ZnO powder is employed actually as a sintered form, which is in turn employed as a direct raw material. The preparation of such a sintered form greatly affects the growth of the single crystal. The ZnO for producing a sintered form is preferably provided as a ZnO powder whose mean particle size is about 1 micrometer and the ZnO powder is placed in a platinum mold where it is pressed prior to sintering. As a result, the formation of microcrystals upon growing is suppressed and the loss of the raw material due to the microcrystal formation can be avoided.

The sintering is conducted preferably at a temperature of 1100°C or higher in an oxidative atmosphere for the purpose of obtaining a suitably slow dissolution rate of the ZnO sintered form. A low temperature leads to an excessively high dissolution rate of the ZnO sintered form, resulting in a reduced quality of the grown crystal. A possible risk of transportation of a remaining ZnO powder to the crystal growth part due to the thermal convection which may lead to deposition on crystal seeds should be avoided by any means. Among the resultant sintered bodies, those of 5 to 80 mm$\phi$ (in case of non-spherical shape, diameter of a sphere having an identical volume) are placed appropriately in the raw material charge part. While the shape of a ZnO sintered form is not limited particularly, it may be a disc, cube, rectangular parallelepiped and the like. In view of the uniformity of the dissolution in a solvent, a sphere is preferable.

Also upon growing a crystal, a crystal seed is employed usually. While the shape of such a crystal seed may be a quadratic prism, hexagonal prism, cylinder and the like, it is preferable to use a crystal seed in the form of a hexagonal prism or hexagonal plate for the purpose of stabilizing all azimuthal quality of the crystal. The direction to which a crystal seed is arranged is not limited particularly, and is preferably selected such that the angle between the c axis of the crystal seed and the oxide solvent convection direction becomes 0 to 180° (excluding 0 and 180°), particularly 60° to 120°. By using such a crystal seed thus arranged, a ZnO single crystal is grown eccentrically with regard to the crystal seed, whereby allowing a larger single crystal to be obtained.

Furthermore, a crystal seed may be one formed by joining the crystal seeds with each other. In such a case, the joining is effected with the c axis polarities being in agreement with each other and then a hydrothermal synthesis or a gas phase method such as an MOCVD method is conducted to utilize a homoepitaxial effect, whereby allowing the dislocation at the junction to be reduced. Also by joining the crystal seeds with each other as described above, a crystal seed which is large in the direction of the c axis can be obtained even if the growth is effected selectively in the direction of the a axis. In such a case, an agreement not only of the c axis polarity but also of the a axis polarity is ensured upon joining, and thus it is preferred to join the crystal seeds having an identical shape to each other.

When joining the crystal seeds with each other, the joining surface is preferably polished into a smoothness at a mirror surface level. A polishing into a smoothness at an atomic level is further preferred. While the polishing method is not limited particularly, it may employ an EEM processing (Elastic Emission Manching). While the abrasive employed here is not limited particularly, it may for example be $SiO_2$, $Al_2O_3$, $ZrO_2$ and the like with a colloidal silica being preferred.

While a ZnO single crystal is a hexagonal system crystal, its axial growth rate can be controlled by adjusting the growth condition. The growth in the c axis direction can be promoted by allowing potassium (K) to coexist during the growth. For this purpose, the KOH described above can be used as a dissolution fluid or a mineralizer. The growth in the a axis direction can be promoted preferably by allowing lithium (Li) to coexist. For this purpose, LiOH can be used as a dissolution fluid or a mineralizer as described above.

In such a case, upon the crystal growth, an alkaline solvent comprising KOH in an amount of 1 to 6 mol/l and LiOH in an amount of 1 to 3 mol/l is usually allowed to coexist with a ZnO raw material. Examples of preferred concentrations of KOH and LiOH are 3 mol/l and 1 mol/l, respectively. With regard to the behavior in response to variation in the alkaline concentration, a reduced LiOH concentration leads to a enhanced growth rate in the direction of the c axis, allowing needles to be formed frequently. It is considered that a large amount of impurities such as iron is introduced into the crystal because of an insufficient prevention of the erosion of the inner wall of the growth chamber caused by an increased concentration of the alkaline solvent. If necessary, $H_2O_2$ can be present usually at a level of about 0.01 to 0.5 moles per 1 liter of an alkaline solvent for the purpose of achieving a high purity of the resultant ZnO single crystal.

Next, a material for the ZnO sintered form, solvent and the like, are charged into a growth chamber made of a highly heat resistant and highly anti-corrosive material, where a crystal growth is effected. Among the highly heat resistant and highly anti-corrosive materials, platinum (Pt) is preferred since it has a high strength, and satisfactory stretching and welding performances. A preferred embodiment of this growth chamber is, firstly, one whose inside is coated or metallized with platinum (Pt). Secondly, a structure having a zone of a crystal growth region surrounded by a platinum (Pt) liner inside of the chamber is exemplified. Thirdly, another example is a structure in which a baffle plate placed horizontally in the chamber serves to partition the chamber into a raw material charge region in which a ZnO sintered form is charged and a crystal growth region containing a wire and the like for arranging a ZnO crystal seed.

It is preferable that such a baffle plate, wire and the like are made of platinum (Pt) or covered with platinum (Pt) in any part in the growth chamber and. Fourthly, a structure in which a crystal consisting of a relatively small-sized ZnO single crystal is placed beneath the top of the chamber (in a crystal growth part when using a baffle) is exemplified. Such a baffle plate preferably has an opening ratio of 5 to 15% (excluding 5%).

Also by allowing a raw material to be present between the raw material charge part and the crystal seed part, the rate at which the crystal growth part is brought into a supersaturation state can be increased, whereby avoiding various disadvantageous behaviors upon disslocation of the crystal seed. In such a case, the amount of the raw material to be supplied onto the baffle plate is preferably 0.3 to 3 times the amount of ZnO dissolved in the crystal growth part. In order to control the supersaturation degree appropriately, the ratio of the crystal growth part capacity to the raw material charge part capacity is kept preferably within 1 to 5 times.

A supersaturation degree exceeding 1.50 leads to a too high rate of the precipitation on the crystal seed, resulting in a poor integrity inside of the crystal formed with a tendency of introducing defects. It also gives a large amount of the precipitation on the inner wall and the frame of the growth chamber, and such a precipitation, if becoming larger, is brought into contact with a ZnO single crystal which may then lead to prevention of the single crystal growth, and accordingly it is preferable that the supersaturation degree is not too high.

As used herein, the term "supersaturation" means a state where the solute level exceeds the saturation state, while the term "supersaturation degree" means a ratio of the supersaturated solute level to the saturated solute level. In a hydrothermal synthesis, the ratio of the ZnO solute level in the crystal growth part in a supersaturation state as a result of the transportation of ZnO from the starting material charge part via a thermal convection and the ZnO solute level in a saturation state in the crystal growth part is applicable.

Supersaturation degree = (supersaturated solute level in crystal growth part/saturated solute level in crystal growth part)

The supersaturation degree discussed here can be controlled by adjusting and setting the ZnO raw material density, ratio of baffle plate opening, difference in the temperature between the raw material charge part and the crystal growth part and the like.

In the growth chamber, a precipitation collection net may be provided above the crystal seed position, i.e., near the convergent point of the solvent convection. Such a precipitation collection net serves as described below. Thus, while the solvent convection, i.e. the solute transporting flow goes into a lower temperature region as it goes upward in the growth chamber, the solute in such a low temperature supersaturation state may undergo the precipitation not only on the crystal seed but problematically also on the noble metal lead holding from which the crystal seed is hanging, on the frame fixing this noble metal lead, and also on the inner wall of the growth chamber. Under such a circumstance, if the precipitation collection net is provided near the convergent point of the convection and the solute which missed precipitating on the crystal seed is inverted downward by the ceiling of the chamber, the microcrystals and the precipitates in the transportation flow can be collected while forcing the microcrystals to precipitate selectively on this collection net. In such a case, it is another preferred embodiment that the ceiling is formed in a dome-like shape whereby inverting the convection flow near the ceiling smoothly. The material for this collection net is preferably platinum (Pt) similarly to the baffle plate and the crystal seed holding wire.

As a growth chamber, a design involving the growth chamber cylinder sealed for example with platinum (Pt) lining as described above which is to be placed for example in an autoclave can be employed, whereby preventing migration of impurities into the system completely. In such a case, it is preferable to charge the pressurizing medium in an appropriate amount so that the pressure between the platinum (Pt) lining and the autoclave becomes similar to that inside of the lining. While the size of the autoclave is no limited particularly, a medium-sized one whose inner diameter is $\phi$200 and whose height is 3000 mm allows an about 2 inch-sized zinc oxide (ZnO) single crystal to be obtained readily. The pressurizing medium may be one poorly corrosive at high temperature under high pressure, and is preferably distilled water. While such a pressurizing medium exerts a pressure at a given growth temperature depending on the filling ratio based on the capacity remaining when placing the growth chamber in the autoclave (hereinafter referred to as a "free capacity"), this pressure is adjusted to a level equal to or slightly higher than the pressure inside of the growth chamber by adjusting the filling ratio of the pressurizing medium, whereby functioning to protect the growth chamber. In the case of the solvent and the solvent temperature described above, if distilled water is employed as a pressurizing medium, the filling ratio is preferably about 60 to 90%, based on the free capacity of the autoclave.

It is also preferable to provide a pressure controlling part by any means capable of adjusting the difference in the pressure between the inside of the growth chamber and the inside of the autoclave described above at a high temperature under a high pressure during the crystal growth. Such a pressure controlling part may for example an expandable and contractible bellows mounted in such a manner that the inside of the growth chamber is sealed.

The growth of an inventive ZnO single crystal can be accomplished for example by placing the autoclave described above in a furnace, increasing the temperature of the growth chamber described above whereby heading the crystal growth part and the raw material charge part described above at predetermined temperatures. The alkaline solvent is infused in an amount of about 60 to 90% based on the free capacity, i.e., the volume remaining after placing the ZnO sintered form, the baffle plate and the like in the chamber. The growth is conducted preferably in a supercritical state at a high temperature under a high pressure (usually 300 to 400°C, 500 to 1000 atm).

By adjusting here the temperature of the crystal growth part at a temperature lower by about 15 to 50°C than that of the raw material charge part, the convection occurs and the raw material dissolving at the dissolution region goes up to the growth part where it precipitates to allow the crystal to grow on the crystal seed. A too small difference here in the temperature between the dissolution region and the growth region results in an extremely low growth rate, while an excessive difference in the temperature results in an increased frequency of defects such as needles.

For the details of the crystal growth part and the raw material charge part with regard to the growth temperature, it is preferable to set the crystal growth part at 300 to 360°C and the raw material charge part at 340 to 400°C. Under this condition, the operation is continued constantly for 30 to 200 days to allow the crystal to grow, and thereafter the heating furnace is switched off to allow to room temperature, at which the ZnO single crystal is taken out. The resultant bulk of the single crystal can be washed with hydrochloric acid (HCl), nitric acid (HNO$_3$) and the like.

An inventive zinc oxide (ZnO) produced by the method described above is as large in size as 5 cm in major diameter which can not achieved by the prior art. While there is no particular upper limit of such a size, one whose major diameter is about 15 cm is considered usually to be produced. The concentration of the metals other than zinc in such a ZnO single crystal of the invention fulfills the following equation:

$$[-cM]/[+cM] \geq 3$$

wherein M is a metal other than zinc, [-cM] is a concentration of M in a -c region in the zinc oxide crystal, and [+cM] is a concentration of M in a +c region in the zinc oxide crystal.

In a preferred embodiment of the invention, the range of [-cM]/[+cM] is 5 or more, more preferably 10 or more, particularly 20 or more. When the [+cM] value becomes small, [-cM]/[+cM] value becomes extremely large, the upper limit of the latter is usually about 100.

A metal component in a crystal can usually be measured by ICP-MS or GDMS.

The non-patent reference 1 described above taught that in a ZnO crystal lithium (Li) in an alkaline solvent used in a hydrothermal synthesis is contained in a larger amount in a -c region than in a +c region, because in the crystal structure of the ZnO the -c region contains a larger number of defects than the +c region and tends to adsorb and incorporates impurities. However, since a condition of a hydrothermal synthesis of a ZnO single crystal reported conventionally allows the metals other than zinc migrating into the crystal during the growth to be present at a level as high as several tens ppm, the unevenness of the metal distribution between the -c region and the +c region observed in an inventive ZnO single crystal represented by the equation shown above was not identified. On the other hand, a ZnO single crystal of the invention avoids the migration of the impurities as far as possible while specifying the crystal growth condition precisely, resulting in a stable distribution of the trace metal components other than zinc.

Based on the ability of stabilizing the distribution of the trace metal components by the crystal growth process, a method using a raw material containing the trace metal components or a method comprising immersing a grown single crystal in a solution of the trace metal components followed by effecting a diffusion at a high temperature to accomplish a doping may be employed to obtaining a composition having desired trace metal components.

In an inventive ZnO single crystal, the relationship shown in the equation shown above becomes evident especially when limiting the metal other than zinc in the single crystal to divalent and/or trivalent metals. While the divalent or trivalent metal is not limited particularly, it is usually iron (Fe) or aluminum (Al) which is present mainly in a ZnO single crystal of the invention as a component other than zinc.

A metal contained in a ZnO single crystal is present at a level usually of 3 to 100 ppm, preferably 5 to 100 ppm, more preferably 10 to 100 ppm in a -c region in the case of iron (Fe). Similarly, the level in a +c region is usually 0.01 to 1.0 ppm, preferably 0.01 to 0.5 ppm, more preferably 0.01 to 0.3 ppm.

In the case of aluminum (Al), the level in a -c region is usually 1.5 to 10.0 ppm, preferably 2 to 10 ppm, more preferably 2.5 to 10 ppm. Similarly, the level in a +c region is usually 0.01 to 0.5 ppm, preferably 0.01 to 0.25 ppm, more preferably 0.01 to 0.1 ppm.

Also in a crystal growth by a hydrothermal growth, the contamination with lithium (Li) and potassium (K) cannot be avoided usually since LiOH and KOH are employed usually as mineralizers. They exhibit less significant unevenness in the level between a -c region and a +c region, and lithium (Li) is present usually at 0.1 to 30 ppm in each region. Potassium (K) is present usually at 0.01 to 0.3 ppm in each region.

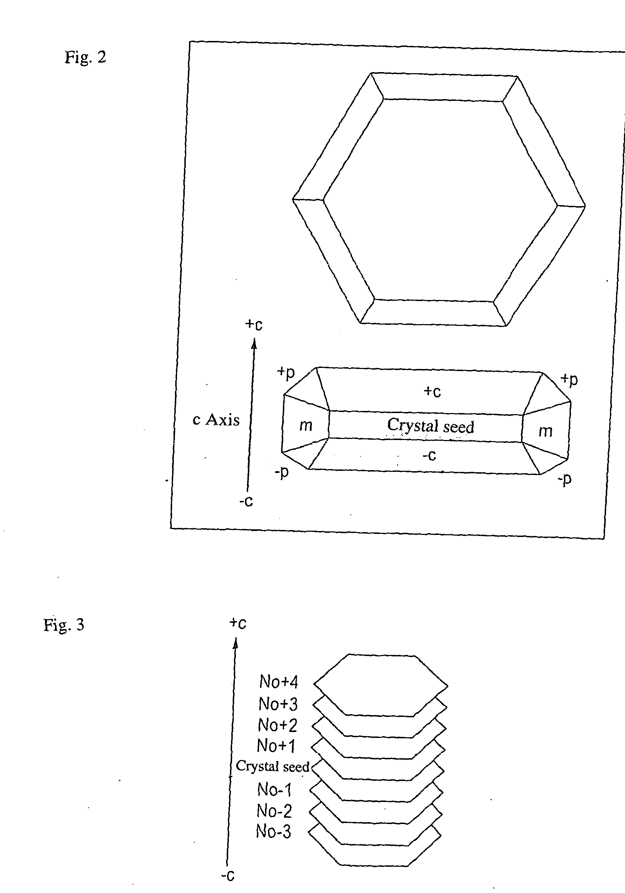

When dividing an inventive ZnO single crystal by a crystal seed in the direction of a c axis into a +c region and a -c region, the growth mechanism is different between the regions, resulting in a green-colored appearance at a first sight. However, such an appearance is due to the coloration in -c and +p regions in the crystal growth regions shown in Fig. 2, and the transparency of the +c and m regions is high.

Accordingly, a ZnO single crystal of the invention, when cut out as the +c region with the crystal seed being the center, exhibits a high transparency, which allows it to be employed usefully as an optical material. On the contrary, the coloration in the -c region may be due to the contamination with iron (Fe) and oxygen deficiency accompanied therewith.

A ZnO single crystal of the invention is unique consequently also in terms usually of its infrared absorption characteristics. Thus, a crystal in the +c region having a low carrier concentration exhibits almost no absorption in the infrared range, and the transmittance at 8000 to 1500 (/cm) is usually 80% or higher, especially 85% or higher. On the other hand, a crystal in the -c region having a high carrier concentration exhibits a high absorption starting at about 1500 (/cm) which is in an infrared short wavelength range, and a substantial difference is observed also in the infrared range between the +c region and the -c region.

A ZnO single crystal of the invention is unique also in terms of its electric characteristics. Its electric resistance varies greatly depending on the growth region, and is about $10^2/\Omega \cdot cm$ in the +c region and $10^{-1}/\Omega \cdot cm$ in the -c region. Assumed from the impurity distribution, Li migrating as an impurity into the +c region serves as an acceptor to impart a substrate with a high resistance. When compared with the +c region, the -c region receives a larger amount of impurities such as Al and Fe, which give a higher density of oxygen defects and serve as donors together with their complexes, possibly resulting in a reduced resistance.

The carrier of a zinc oxide (ZnO) of the invention has a density usually of $5.0 \times 10^{14}$ to $1.0 \times 10^{18}$ (/cm), and $10^{12}$ to $10^{16}$ (/cm) especially in the +c region, and $10^{15}$ to $10^{20}$ (/cm) in the -c region. Its mobility (the rate of movement) is usually 120 to 4000 ($cm^2$/V·sec). Such carrier density and mobility are usually at similar degrees between the + region and the - region.

EXAMPLES

The invention will be explained below in more detail by reference to examples, but the invention should not be construed as being limited to the following examples.

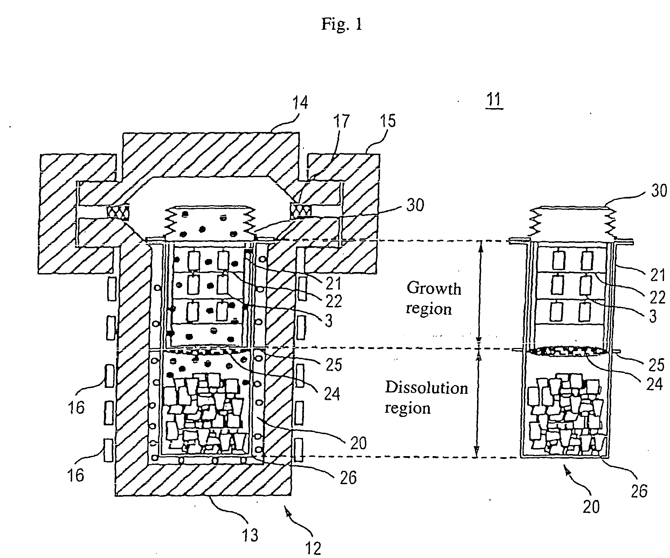

Using a single crystal growth apparatus having a structure shown in Fig. 1, a ZnO single crystal was grown. The single crystal growth apparatus 11 shown in Fig. 1 comprises an autoclave 12 which can impart its inside with a temperature and a pressure required for growing the ZnO single crystal and a growth chamber 20 housed in the autoclave 12. The autoclave 12 has a structure that, for example, a chamber body 13 of the autoclave 12 formed from a high tension steel containing iron as a main component, is covered via a packing 17 with a lid 14 whose fixation is ensured with a fixing part 15, thereby to airtight-include the inside thereof. A growth chamber 20 used as being housed in the autoclave 12 is made of platinum (Pt) and has a shape approximating a cylinder. On the top, a bellows 30 serving as a pressure controlling part is fixed while sealing the inside of the growth chamber 20.

In such a single crystal growth apparatus 11, a frame 21 and a platinum lead 22 are provided beneath the top of the growth chamber 20 to suspend a ZnO crystal seed 3, under which a raw material 26 is provided to allow the crystal seed 3 to grow, whereby effecting the growth of the ZnO single crystal. Between the ZnO crystal seed 3 and the raw material 26, an internal baffle plate 24 is provided for controlling the thermal convection, and this internal baffle plate 24 serves to partition the inside of the growth chamber 20 into a dissolution region and the growth region. The internal baffle plate 24 has a plural of pores, the number of which determines the opening area of the baffle plate 24, which is set at 10% here, although said opening area can be set as desired for controlling the convection level from the dissolution region to the growth region whereby exerting an effect on the crystal growth rate. Outside of the growth chamber 20, an external baffle plate 25 is provided, and this external baffle plate 25 serves to control the convection outside of the growth chamber 20, whereby ensuring the difference in the temperature required for the growth of the crystal seed 3 between the regions in the growth chamber.

Using the single crystal growth apparatus 11 described above, a hydrothermal synthesis can be conducted to grow a ZnO single crystal from a crystal seed. With almost no contamination with impurities in the growth chamber 20, a ZnO single crystal having a diameter utilizable industrially can be grown by selecting the number of days for the growth appropriately depending on the application.

A ZnO powder whose purity was 99.9999% was compacted in the molding container, and then sintered at 1100°C for 24 hours to obtain a solid; which was placed in the growth chamber 20. Then, a purified water containing 1 mol/l of LiOH and 3 mol/l of KOH dissolved therein was infused as a mineralizer in a volume of 80% of the free capacity, and then 0.05 mol/l of $H_2O_2$ was further infused. Thereafter, the growth chamber 20 was fused with the bellows, whereby imparting a complete seal with the inside of the growth chamber. For the thermal conductivity between the autoclave 12 ($\phi$200 × 300 mm) and the growth chamber 20, a purified water in a volume of 80% of the free capacity was charged. The autoclave 12 comprises a chamber body 13 and a lid 14, and the chamber body 13 and the lid 14 were engaged with each other while being fixed tightly by a fixation part 15 while sandwiching the packing 17 to make the inside air-tight.

Thereafter, a heater 16 was operated to heat the dissolution region and the growth region. Upon heating, the temperature of the dissolution region was kept at a temperature higher by 15 to 50°C than the temperature of the growth region, and the heating was effected to obtain the final temperatures of about 360°C in the dissolution region and about 310°C in the growth region. The raw material dissolved in the dissolution region went up by the convection, and then precipitated near the crystal seed 3 in the growth region, whereby allowing the crystal seed to grow to yield a ZnO single crystal. In this state, the operation was continued constantly for 60 days to allow the crystal to grow at a rate of about 0.2 mm/day each in the direction of the c axis and the a axis, and thereafter the inside of the system was allowed to return to room temperature and atmospheric pressure, at which point the ZnO single crystal whose major diameter was about 5 cm was taken out.

The appearance of the zinc oxide single crystal thus obtained is shown in Fig. 2. As a seed, a c plate (a thin plate of ZnO at a right angle to the c axis) was employed. Fig. 3 shows a sectional view when being cut at the center at a right angle to the c axis of the zinc oxide single crystal, together with the designations of the growth regions.

The ZnO single crystal thus obtained was analyzed by the procedure described below. The surface of each sample obtained by slicing the ZnO single crystal at a right angle to the c axis at an interval of 1 mm was washed with a dilute nitric acid and the distilled water prior to dissolution using nitric acid and hydrochloric acid. The solution thus obtained was quantified by a standard addition method using an ICP-QMS (Yokogawa Analytical Systems Inc., Model HP4500). The metal levels thus measured on each surface (No.-3 to No.+4) at a right angle to the c axis are shown in Table 1 (where the data are in ppm). Here the data are of 4 metals at high levels. According to these results, the metal components exhibited uneven existence between the +c region and the -c region, which was evident especially in the cases of Fe and Al.

When a ZnO single crystal was produced using a structure having the chamber body 13 and the lid 14 covering the chamber body via the packing 17 just with the aid of the fixation point 15 instead of using the bellows 30 serving for a air-tight structure as described above, the incorporation of the trace metal components which were migrated readily as impurities could not be avoided, resulting in each slice containing Al in an amount of about 20 ppm, and Fe in an amount of about 1000 ppm. The distribution of the concentrations of the metal components showed no marked difference between slices.

Table 1

|       | Fe   | Al   | Li   | K    |
|-------|------|------|------|------|
| No-3  | 5.4  | 1.9  | 0.47 | 0.17 |
| No-2  | 6.0  | 2.1  | 3.5  | 0.04 |
| No-1  | 11.0 | 2.4  | 12.0 | 0.06 |
| No+1  | 0.43 | 0.11 | 6.6  | 0.09 |
| No+2  | 0.48 | 0.33 | 6.1  | 0.17 |
| No+3  | 0.22 | 0.09 | 1.5  | 0.23 |
| No+4  | 0.55 | 0.30 | 5.7  | 0.09 |

As an electric property, a hole property in a + region at each temperature (shown as an inverse number of temperature T) is shown in Table 2. It indicates that a high carrier concentration (unit is "/cm$^3$") and a high mobility (unit is "cm$^2$/V·sec") were obtained even at room temperature.

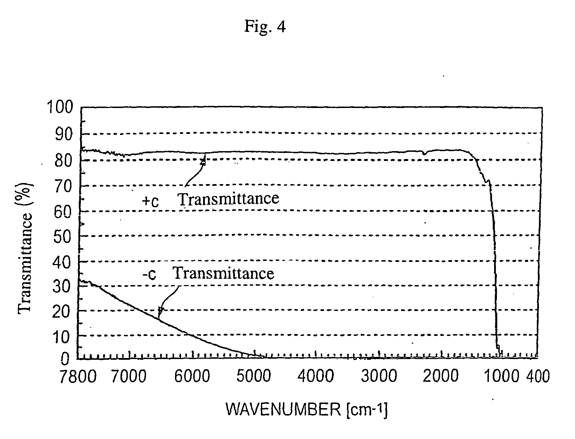

Furthermore, as an optical property of the crystal, the infrared spectrum property in the +c region and the -c region were measured and the results are shown in Fig. 4. Based on these findings, there was almost no infrared absorption in the +c region, while there was a substantial infrared absorption in the -c region.

Table 2

| 1/T (K × 10$^3$) | Mobility | Carrier density |
|------------------|----------|-----------------|
| 3.41             | 205      | 2.20E+17        |
| 4.29             | 240      | 2.60E+17        |

Table continued

| 1/T (K $\times 10^3$) | Mobility | Carrier density |
|---|---|---|
| 5.18 | 320 | 1.60E+17 |
| 5.78 | 390 | 1.20E+17 |
| 6.53 | 340 | 1.20E+17 |
| 8.84 | 340 | 6.80E+16 |
| 10.74 | 410 | 2.90E+16 |

While the invention has been described in detail and with reference to specific embodiments thereof, it will be apparent to one skilled in the art that various changes and modifications can be made therein without departing from the spirit and scope thereof.

This application is based on a Japanese patent application filed on April 3, 2003 (Application No. 2003-100861), the contents thereof being herein incorporated by reference.

INDUSTRIAL APPLICABILITY

According to the invention, a high quality zinc oxide (ZnO) single crystal having an excellent electroconductivity can be provided.

**Claims**

1.  A zinc oxide single crystal whose concentration of metals other than zinc in the crystal fulfills the following equation:

$$[-cM] / [+cM] \ \geq \ 3$$

wherein M is a metal other than zinc, [-cM] is a concentration of M in a -c region in the zinc oxide crystal, and [+cM] is a concentration of M in a +c region in the zinc oxide crystal.

2.  The zinc oxide single crystal according to claim 1, wherein the metal (M) other than zinc is a divalent metal or trivalent metal.

3.  The zinc oxide single crystal according to claim 2, wherein the divalent metal or the trivalent metal is iron (Fe) or aluminum (Al).

4.  The zinc oxide (ZnO) single crystal according to claim 3, wherein the concentration [-cFe] of iron (Fe) in a -c region in the zinc oxide single crystal is 3 to 100 ppm while the concentration [+cFe] of iron (Fe) in a +c region is 0.01 to 1.0 ppm.

5.  The zinc oxide (ZnO) single crystal according to claim 3, wherein the concentration [-cAl] of aluminum (Al) in a -c region in the zinc oxide single crystal is 1.5 to 10 ppm while the concentration [+cAl] of aluminum (Al) in a +c region is 0.01 to 0.5 ppm.

6.  The zinc oxide single crystal according to any of claims 1 to 5, wherein the mobility is 120 to 4000 (cm$^2$/V·sec).

7.  The zinc oxide single crystal according to any of claims 1 to 6, wherein the carrier concentration is $5.0 \times 10^{14}$ to $1.0 \times 10^{18}$ (/cm$^3$).

8.  The zinc oxide single crystal according to any of claims 1 to 7, wherein the longer diameter is 5 cm or more.

9.  The zinc oxide single crystal according to any of claims 1 to 8, wherein the infrared transmittance at 8000 to 1500 (/cm) in a +c region is 80% or more.

**10.** The zinc oxide single crystal according to any of claims 1 to 7, which is produced by a hydrothermal synthesis.

Fig. 1

14  17  15          11

30

21
22
3

Growth
region

25
24

Dissolution
region

16

16

20

16

26

13

12

20

30

21
22
3

25
24

26

Fig. 2

+c

c Axis

+p    +c    +p

m    Crystal seed    m

-p    -c    -p

-c

Fig. 3

+c

No+4
No+3
No+2
No+1
Crystal seed
No-1
No-2
No-3

-c

Fig. 4

**INTERNATIONAL SEARCH REPORT**

| International application No. |
| --- |
| PCT/JP2004/004850 |

| A. CLASSIFICATION OF SUBJECT MATTER |
| --- |
| Int.Cl⁷ C30B29/16, C30B7/10 |

According to International Patent Classification (IPC) or to both national classification and IPC

| B. FIELDS SEARCHED |
| --- |
| Minimum documentation searched (classification system followed by classification symbols) |
| Int.Cl⁷ C30B29/16, C30B7/10 |

Documentation searched other than minimum documentation to the extent that such documents are included in the fields searched

| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)
CAS ONLINE, WPI, JSTPlus(JOIS)

| C. DOCUMENTS CONSIDERED TO BE RELEVANT | | |
| --- | --- | --- |
| Category* | Citation of document, with indication, where appropriate, of the relevant passages | Relevant to claim No. |
| X<br>Y | T. SEKIGUCHI et al., Hydrothermal growth of ZnO single crystals and their optical characteriza tion, Journal of Crystal Growth, 2000, Vol.214/ 215, pages 72 to 76, column of '3. Results and discussion' | 1-5,9,10<br>6-8 |
| X<br>Y | A. URBIETA et al., Cathodoluminescence and scanning tunneling spectroscopy of ZnO single crystals, Materials Science and Engineering, 2002, B91-92, pages 345 to 348, column of '3. Results and discussion' | 1-5,9,10<br>6-8 |
| Y | JP 6-90036 A (NGK Insulators, Ltd.), 29 March, 1994 (29.03.94), Claims 1 to 3; Par. Nos. [0012], [0013] & EP 587407 A2 & US 5393444 A | 6,7 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>31 May, 2004 (31.05.04) | Date of mailing of the international search report<br>15 June, 2004 (15.06.04) |
| --- | --- |
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
| --- |
| PCT/JP2004/004850 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | EP 1152073 A1 (SAWYER RESEARCH PRODUCTS INC.),<br>07 November, 2001 (07.11.01),<br>Par. Nos. [0050], [0067]<br>(Family: none) | 8 |

Form PCT/ISA/210 (continuation of second sheet) (January 2004)